# EUROPEAN PATENT SPECIFICATION

(11) **EP 3 550 581 B1**
(45) Date of publication and mention of the grant of the patent: **07.02.2024**
(21) Application number: 18194768.0
(22) Date of filing: 17.09.2018
(51) Int. Cl.: H01H 9/54, H01H 33/59

(54) **METHODS AND APPARATUS FOR DC ARC DETECTION/SUPPRESSION**
VERFAHREN UND VORRICHTUNG FÜR GLEICHSTROMLICHTBOGENDETEKTION/-UNTERDRÜCKUNG
PROCÉDÉS ET APPAREIL DE DÉTECTION/SUPPRESSION D'ARC CC

(30) Priority: 06.04.2018 US 201815947602
(43) Date of publication of application: 09.10.2019
(73) Proprietor: Yazaki North America, Inc., Canton, Michigan 48187 (US)
(72) Inventor: WU, Yuanyuan, Canton, MI 48187-3500 (US)
(74) Representative: Grünecker Patent- und Rechtsanwälte PartG mbB

(56) References cited:
- EP-A2- 0 102 442
- WO-A1-2008/153960
- FR-A1- 2 738 664
- US-A1- 2004 052 011
- US-A1- 2009 014 631
- US-A1- 2010 007 997

## Description

### BACKGROUND

An electric arc (also known as an arc discharge) is an electrical breakdown of a gas that produces an ongoing electrical discharge. Current passing through a medium produces plasma, which may generate visible light. An arc discharge involves a lower voltage than a glow discharge, and is based on thermionic emission of electrons from the electrodes supporting the arc.

An arc is distinguished from a glow discharge partly by the approximately equal effective temperatures of both electrons and positive ions, however glow discharges involve ions with much less thermal energy than the electrons. More specifically, an electric arc differs from a glow discharge in that the current density is high, and the voltage drop within the arc is low. In fact, the current density at a cathode can be as high as one megaampere per square centimeter.

An electric arc provides an electric discharge with the highest current density, and the maximum current through an arc is limited only by the external circuit. The breakdown voltage of the electrode gap is a combined function of the pressure, distance, and temperature between electrodes and type of gas surrounding the electrodes.

An electric arc may occur either in direct current (DC) circuits or in alternating current (AC) circuits, and can be initiated by two electrodes initially in contact and drawn apart. For example, an arc can be created by separating electrical contacts in switches, relays or circuit breakers. An electric arc is a continuous discharge, while a similar electric spark discharge is momentary.

Arcing can also occur when a low resistance channel (foreign object, conductive dust, moisture, etc.) forms between places with different voltages. The conductive channel can facilitate formation of an electric arc. The ionized air has high electrical conductivity approaching that of metals, and it can conduct extremely high currents, causing a short circuit and tripping protective devices (fuses and circuit breakers). A similar situation may occur when a lightbulb burns out and the fragments of the filament pull an electric arc between the leads inside the bulb, leading to overcurrent that trips the breakers.

Electrical resistance along the continuous electric arc creates heat, which ionizes more gas molecules and the degree of ionization is determined by temperature. An electric arc has a non-linear relationship between current and voltage. Once the arc is established, such as by progressing from a glow discharge or alternatively by momentarily touching the electrodes and then separating them, increased current results in a lower voltage between the arc terminals. The negative resistance causes positive impedance, i.e., an electrical ballast, to be placed in the circuit to maintain a stable arc. Uncontrolled electrical arcs in apparatus can be incredibly destructive because an arc draws an increasing current from a fixed-voltage supply until the apparatus is damaged or destroyed.

Document EP 0 102 442 A2 describes an active arc suppression circuit for direct current switches. A bipolar transistor is employed to actively shunt the load current around a mechanical switch, and which an arc may develop when its contacts are opened.

### SUMMARY

Unintended or undesired arcing can occur in many different contexts, including with automotive electrical components and wiring, such as with regard to an automotive wire harness. Electric arcing in this context can have detrimental effects on electric power transmission, distribution systems and electronic equipment. Devices that may cause arcing include switches, circuit breakers, relay contacts, fuses and poor cable terminations. When an inductive circuit is switched off, the current cannot instantaneously change to zero, and so a transient arc may be formed across the separating contacts. If a circuit has sufficient current and voltage to sustain an arc formed outside of a switching device, then the arc can cause damage to equipment. This damage can take the form of melting of conductors, destruction of insulation, fire, etc.

Electrical arcs also form new chemical compounds from the air surrounding the arc, such as oxides of nitrogen and ozone. These chemicals can be produced by high-power contacts in relays and motor commutators, and are corrosive to adjacent metal surfaces. Arcing also erodes the surfaces of the contacts, wearing them down and creating high contact resistance when closed.

Undesired arcing at electrical contacts of contactors, relays and switches can be reduced by contact arc suppressors and RC Snubbers, or through techniques including immersion in transformer oil, dielectric gas or vacuum, arc chutes, magnetic blowouts, pneumatic blowouts, sacrificial arcing contacts, damping materials to absorb arc energy, either thermally or through chemical decomposition. Arcing can also be reduced, suppressed, or eliminated using a MCU based closed loop control that disables the power source, and other techniques that use capacitors, opto-couplers and triacs based control circuits.

However, the related art arc suppression techniques are subject to one or more disadvantages, such as in automotive applications. These disadvantages include but are not limited to exhibiting performance limitations, being costly, complicated, difficult to install, a lack of durability and/or longevity, etc.

It may therefore be beneficial to provide methods and apparatus for DC arc detection and/or suppression, such as for automotive applications that address or solve one or more of the above disadvantages of the related art. Some of the disclosed embodiments are specifically directed to DC arc detection and/or suppression methods and apparatus exhibiting enhanced performance and cost effectiveness in automotive applications.

This is achieved by the features of the independent claims.

In general, some embodiments include a circuit that is configured and usable to detect a DC arcing condition and to provide a by-pass for the arcing energy, which yields various advantages, such as protecting automotive wire harness components, e.g., connectors, contact connections, etc.

In some embodiments, voltage is captured when the terminal contacts are open or closed and shaped into a time duration pulse, which enables the FET or bypass circuit to be able to shunt the arc energy for a set time that is helpful or necessary to reduce or suppress the arc. The circuit then shuts off so that no (or a reduced amount of) additional power is drawn for the circuit. Some of these embodiments provide a higher performance (such as a 50% improvement in performance as compared to the related art), and/or a reduced manufacturing cost (such as a 70% reduction as compared to the related art).

The invention is therefore directed to an apparatus according to claim 1.

In some embodiments, the significant voltage spike constitutes a voltage sufficient to cause electric arcing within the component.

The detector circuit includes a capacitor that is directly electrically connected to the input terminal, and a resistor that is directly electrically connected to the capacitor at a side opposite from the input terminal, the resistor also being directly electrically connected to the output terminal. The resistor can provide at least 10 K Ω impedance.

The detector circuit includes a diode that is directly electrically connected to the capacitor at the side opposite from the input terminal, and a Zener diode that is directly electrically connected to the diode. The detector circuit includes another resistor directly electrically connected to the Zener diode at a side opposite from the diode, the other resistor being directly electrically connected to the output terminal, such that the resistor and the Zener diode are in parallel relative to each other. The other resistor can provide an impedance that is substantially less than an impedance provided by the resistor.

In some embodiments, the switching circuit includes a solid state triggerable switch that is configured to receive the control signal from the detector circuit, and upon receipt of the control signal, to conduct electricity from the input terminal to the output terminal. The solid state triggerable switch can be a Field Effect Transistor (FET). The switching circuit can also include a diode electrically connecting the solid state triggerable switch to the input terminal, the diode being configured to limit current between the input terminal and the solid state triggerable switch. The solid state triggerable switch can be a Silicon Controlled Rectifier or an Opto-Electronic Switch.

A method for detecting and suppressing DC electric is described in claim 10.

### BRIEF DESCRIPTION OF THE DRAWINGS

The disclosed subject matter of the present application will now be described in more detail with reference to exemplary embodiments of the apparatus and method, given by way of example, and with reference to the accompanying drawings, in which:
Fig. 1 is a schematic of a related art arc suppression apparatus.
Fig. 2 is a schematic view of another related art arc suppression apparatus in a DC circuit.
Fig. 3 is a schematic of an arc suppression apparatus in accordance with an exemplary embodiment of the presently disclosed subject matter, which is connected to switches and/or connectors that are protected thereby.
Fig. 4 is a schematic of an arc suppression circuit in accordance with an exemplary embodiment of the presently disclosed subject matter.
Fig. 5 is a timing diagram showing operation of an arc suppression circuit in accordance with an exemplary embodiment of the presently disclosed subject matter.

### DETAILED DESCRIPTION OF EXEMPLARY EMBODIMENTS

A few inventive aspects of the disclosed embodiments are explained in detail below with reference to the various figures. Exemplary embodiments are described to illustrate the disclosed subject matter, not to limit its scope, which is defined by the claims. Those of ordinary skill in the art will recognize a number of equivalent variations of the various features provided in the description that follows.

### 1. Related Art Arc Suppression

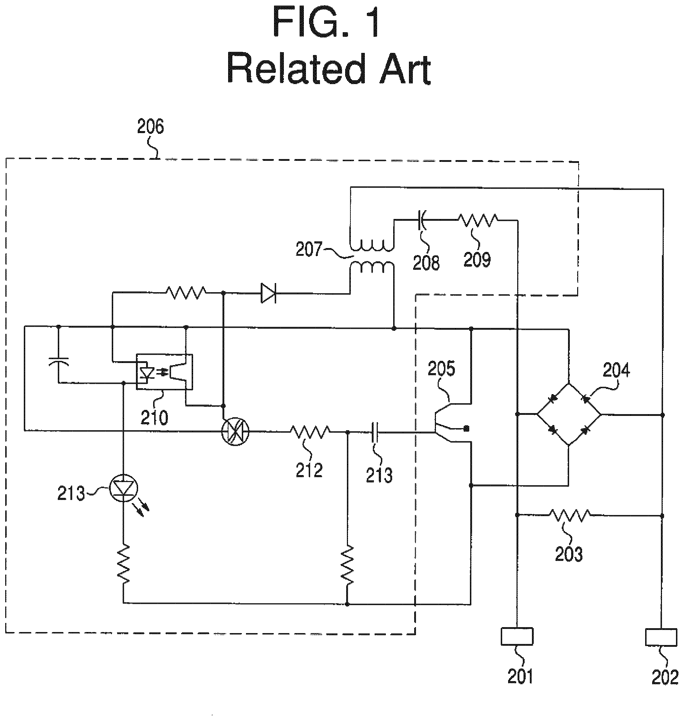

**Fig. 1** is a schematic of a related art arc suppression apparatus, which suppresses arcs for both AC and DC circuits. Two terminals **201** and **202** are bridged by a varistor **203** for surge protection and connected through a rectifier **204** to a switching element **205.** The switching element **205** is triggered by a control circuit **206** whenever there is a risk of arcing. This effectively short-circuits the endangered mechanical connection through an electrical.

The control circuit **206** includes a transformer **207** to reduce the voltage from the protected connection. The transformer **207** is arranged in series with a capacitor **208** and resistor **209** to form an RC circuit. The output of this circuit then triggers an opto-isolator **210,** the output of which is filtered by the RC circuit comprised of the resistor **212** and capacitor **213** to become the control signal for the switching element **205.** A voltage change across the transformer **207** then drives the isolator **210** to trigger the switch **205,** which short-circuits the connections and protects the physical contacts. This pulse also triggers a diagnostic LED **213** to indicate the circuit's operation. Externally, the terminals **201** and **202** will be connected across the protected device, for example by connection to terminals.

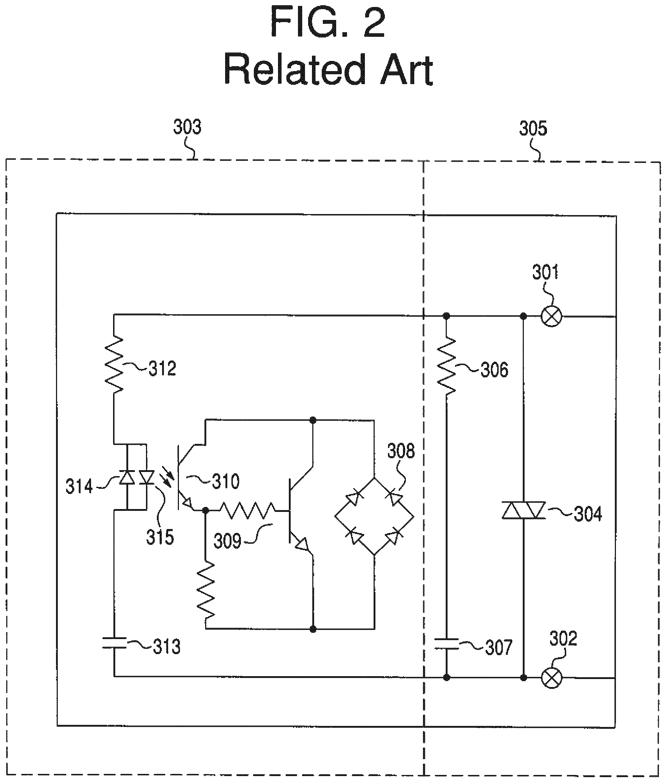

**FIG 2** is a schematic of another related art arc suppression apparatus for a DC circuit. The terminals **301** and **302** are connect to other terminals. These terminals are then connected to a switching circuit **303** in parallel with a voltage regulator **304** and an RC snubber circuit **305,** which includes a resistor **306** and a capacitor **307.**

The switching circuit **303** includes a rectifier **308** bridging the terminals **301** and 302. The rectified output is switched by an NPN switching transistor **309,** which is controlled by an IR detector **310.**

The terminal **301** is also connected to a RC circuit that includes a limiting resistor **312,** a differentiating and timing capacitor **313,** and two IR emitting diodes **314** and **315** arranged in opposite directions. This serves as the control circuit for the solid-state switch.

When the contacts of the switch or relay **104** transition from closed to open, current flows through the capacitor **313,** limited by the resistor **312.** This current causes the IR emitting diode **315** to both charge the capacitor **313** and briefly emit light, which triggers the solid-state switch **303** to short-circuit the contacts of the relay or switch **104.** In the other direction, when the switch or relay **104** transitions from open to closed, the capacitor **313** discharges and current flows through the IR emitting diode **314,** which briefly emits light which triggers the solid-state switch **303** to short-circuit the contacts of the relay or switch **104.**

### 2. Context of Arc Suppression Apparatus of Exemplary Embodiments

Some embodiments are directed to a two-terminal arc suppression apparatus designed to limit arcing across a range of intermittently conducting mechanical connections, including switches and relays as well as plugs, terminals, and components of cable assemblies where the possibility of an air gap (and the resultant arcing) is possible.

In a two-terminal arc suppression circuit, the terminals are used for both arc detection (or, more precisely, arc prediction) and arc suppression. In some embodiments, arc suppression is performed by providing an alternate, entirely electrical, path for current during the period that contacts are opening or closing. This reduces or avoids arcing between the contacts until they are far enough apart or in direct contact so that arcs and their damage are no longer possible.

The alternate electrical path for suppressing the arc is generally provided by some sort of electronic switch, for example a FET or TRIAC. The path needs to become active when the arc is occurring but inactive at other times to avoid either short-circuiting the load during operation or consuming power while the contacts are open. This is generally performed by arranging self-limiting circuits (usually involving a capacitor), which is only active for a short period during which contacts are closing or opening.

The parameters of these self-limiting circuits depend on the physical configuration of the contacts being protected and particularly the duration of the period when arcs are likely.

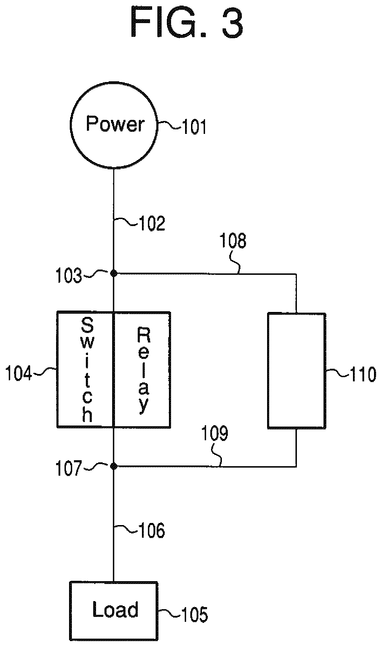

**Fig. 3** is a schematic of an arc suppression apparatus in accordance with an exemplary embodiment, which is connected to switches and/or connectors that are protected thereby. A DC power source **101** is connected by a wire **102** to a terminal **103** of a mechanical switch, relay, or connector **104.** A load **105** is connected by a wire **106** to the second terminal **107** of the switch, relay, or connector **104.**

An embodiment of the invention (arc suppression apparatus) **110** is connected to terminal **103** by a wire **108** and to terminal **107** by a wire **109.** The embodiment of the arc suppression apparatus **110** short circuits the switch or relay **104** when it transitions between open and closed states, avoiding the formation of damaging electrical arcs between the contacts in the switch or relay **104.**

### 3. Overall Arc Suppression Apparatus of Exemplary Embodiments

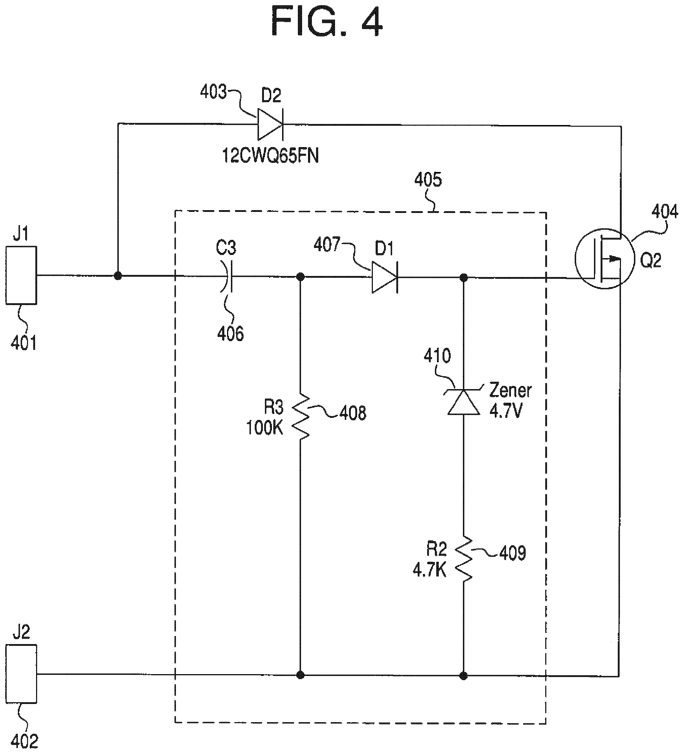

**Fig. 4** is a schematic of an arc suppression circuit in accordance with an exemplary embodiment. The input terminal **401** is connected to a diode **403,** which feeds into the source of a field emission transistor (FET) **404,** a drain of which is connected directly to the output terminal **402.** The terminals **401** and **402** are respectively connected to the terminals **103** and **107** in **FIG 3**. The gate voltage for the FET **404** is generated and controlled by a separate circuit **405** across the terminals. This circuit includes a capacitor **406** connected to the gate input of the FET **404** through a diode **407.** The capacitor **406** is also connected to the output terminal **402** through a high-impedance resistor **408.** The diode **407** also connects to the output through a Zener diode **410** (polarized oppositely) and a resistor **409.**

When the contacts of the switch or relay **104** transition from closed to open, high voltage current flows through the capacitor **406** and the diode **407** to the gate of the FET **404,** which short-circuits the contacts of the switch or relay **401** until the capacitor is saturated. The capacitor **406** discharges when the contacts of **104** transition back from open to closed, again triggering the FET **404** to short circuit, protecting the contacts of the switch/relay/connector **104.**

The terminal **401** serves to connect the inventive arc suppression apparatus **110** to the component (switch, relay, or connector) being protected. This requires a solid electrical connection in order for it (apparatus **110**) to avoid being subject to arcing. The terminal **401** leads directly to both the control circuit for the switching element **404,** and to the switching element itself through the diode **403.**

Some embodiments include two distinct circuits connected only at the switching element **404.** One circuit provides the path that short-circuits the protected component **401** during the period of arc suppression. Another circuit detects the precursors of arcing as the voltage increases across both the protected component **104** and the protective embodiment **110.**

The terminal **401** connects to the switching element **404** through a diode **403.** The diode **403** provides for current steering and over-voltage protection for the switching element **404.** The presence of the diode is beneficial because the arc suppression circuit is active and activated by the high voltages associated with opening and closing of the protected contacts.

In the embodiment shown in FIG 4, the switching element is a FET (Field Effect Transistor) which uses an electric field to allow or interrupt the flow of current from source to sink. This enables the switching element to be solid state and not subject to arcing. It also decouples the control circuit leading into the gate of the FET from the voltage and current flow when the circuit is active.

The sink of the FET leads directly to the output terminal **402,** which is connected to the output of the component being protected **107.** As with the input terminal **401,** the output terminal provides a solid electrical connection to the output **107** of the protected component **104.**

The control circuit of some embodiments is entirely separate from switched path, which short-circuits the component during the critical interval for arcing. The control circuit utilizes a capacitor **406** to specify the interval during which the switching element is active.

Arc detection can be challenging/complicated because it involves the identification of both the opening and the closing of contacts in the protected component **104.** These events are electrically distinct. Closing a contact involves a change of zero voltage to operating voltage through a high voltage region as the contacts near one another. Opening the contacts of the protected component **104** has the opposite profile, involving a change from the operating voltage to zero voltage through a high voltage region as the contacts initially part.

The capacitor **406** operates differently in these two cases. When the contacts of **104** close, the capacitor charges up to its capacity, and current passes through until the capacitor is saturated. This current then feeds the gate of the switching element **404,** enabling the path from **401** to **402,** which suppresses the arc between closed contacts **104** and the risk of arcing has passed.

During normal operation with the contacts of **104** closed, the capacitor **406** remains saturated because there is no path for discharge, due to the high impedance resistor 408 and the opposing polarity Zener diode **410.**

The circuit operates differently when the switch, relay, or contact transitions back from the closed to open state. The high voltage of this transition exceeds the breakdown voltage of the Zener diode **410** and current flows once again, activating the switching element 404 and short circuiting the protected component during the high voltage region where arcing would normally occur.

The Zener diode **410** is connected to the output terminal **402** through a resistor 409. Because the resistor **409** is of lower impedance than the resistor **408,** current will flow primarily through that path, triggering the switching element.

Different calculations may be necessary for different operating voltages, because Zener diodes function differently at voltages below 5.6V (many electronic circuits) and above 5.6V (many automotive applications).

At still higher voltages, it may be beneficial for some embodiments to address the heat generated by the Zener diode during the high voltage period when the suppressor is active. A heat sink or other cooling provision may be used to address or ameliorate this issue.

The duration of the suppression period is controlled by the values of the timing capacitor **406** and the limiting resistors **408** and **409**. These calculations may also consider the residual resistance of the diode during breakdown.

The chosen suppression period may be based on the characteristics of the protected component **104** as well as the typical operating scenarios for the system. For example, in a mechanical switch, the period during which the contacts are close enough to arc will be based on the size of the contacts, their relative geometry, and the mechanics of the switching mechanism. For example, if the contacts on the switch are near the fulcrum of a lever arm, the danger zone for arcing will be longer and the values for components **406, 408,** and **409** should be adjusted accordingly.

On the other hand, in a mechanical connector, the geometry of the connector will constrain this duration because it is defined by how quickly the contacts are separated during connection or reconnection.

Determining these parameters may also take into account the phenomenon of "contact bounce," which is an issue for most or nearly all mechanical switches. This occurs when two physical contacts briefly separate and touch (or touch and separate) before settling into an open or closed state. To address contact bounce, the suppression duration, based on the values of the capacitor **406** and the resistors **408** and **409,** may be increased. In practice, the actual contact bounce behavior of physical switches may be determined experimentally for the particular geometries and materials being used in the switch.

In the case of an electromechanical relay protected by some embodiments, the duration for arc suppression may depend on the magnetic and mechanical characteristics of the relay itself. This can include the electrical characteristics of the magnetic coil, the geometry and material composition of the armature, and the tensile and geometric properties of any springs or other components used to constrain the armature.

Yet another factor in determining the arc suppression duration is the mode of operation of the physical switch being protected. For example, in a manually operated switch, an operator may increase the effective duration of contact arcing by operating the switch slowly or keeping it in a meta-stable condition for an extended period. Because some embodiments are triggered by the high voltage regions that accompany the risk of arcing, it will still function in these cases, but it may "stutter" as the control circuit settles and is re-triggered. In these cases, the contact degradation and other effects of arcing may still occur while being reduced in severity.

Mechanical customization of the physical switching component may reduce some of these types of "operator errors," such as via the inclusion of springs, dogs, locks, or other physical limiters in the actual physical device.

### 4. Timing Diagram

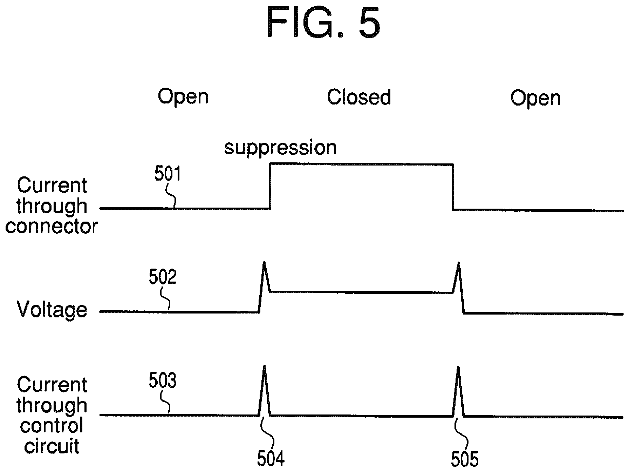

**Fig. 5** is a timing diagram showing an exemplary operation of an arc suppression circuit in accordance with an exemplary embodiment. The first line **501** identifies current through the switch or connector **104.** The second line **502** identifies the voltage across the control circuit **405** during transitions of the switch from open to closed. The third line **503** identifies the current through the control circuit during these transitions.

Current only flows through the control circuit **405** during the suppression intervals **504** and **505.** These are periods of high voltage **502,** when the voltage exceeds the breakdown voltage of the Zener diode **410.** During these periods, voltage is applied to the gate of the FET **404** short-circuiting the contacts of the switch or connector **104** and reducing or avoiding arcing across the contacts.

The current for the gate of the FET **404** originates from the upstream power source **101** on the transition from closed to open, and from the charged capacitor **406** on the transition from open to closed.

### 5. Exemplary Advantages of Some Embodiments

The simple design of some embodiments and the low component count make it advantageous for inclusion in wiring harnesses for automotive and related applications, where there are large numbers of contacts or connectors (with need for arc suppression) throughout the vehicle body.

The passivity of the control circuitry of some embodiments during normal operation (when the contacts are not transitioning between open and closed states) enables a situation where the suppression of arcs does not require significant power and is particularly suitable to applications where it is important to reduce or minimize standing power.

The fact that the circuit of some embodiments is only operational during arc suppression increases its effective lifetime and the mean time between failures. This reduces maintenance costs and increases operational reliability in systems where multiple contacts or switches need to be protected.

The simplicity of the design and the absence of bulky components of some embodiments enables a situation where the physical circuit can be encapsulated in many ways. For example, the circuit can be built into the physical casing of a switch or connector to provide protection for that circuit or connector in particular. This simplifies assembly and decreases production costs. The circuit can also be embodied as a clip-on component, which can be secured around connectors or terminals that may be especially prone (given mechanical or environmental stresses) to arcing.

In automotive applications, the compactness of some embodiments enables the suppression circuit itself to be placed close to the mechanical contacts being protected. This both reduces the overall cost of additional wiring and enhances the effectiveness of the circuit itself, because it reduces or minimizes delay in the detection and suppression of the voltage surges, which lead to arcing.

### 6. Exemplary Alternatives and Modifications

The above description details certain embodiments, which may be modified or altered in various ways.

For example, the switching element **404** in the described embodiment is a field effect transistor (FET), but could be replaced with a different solid state switching element. The FET **404** may be replaced by a silicon-controlled rectifier (SCR) or a thyristor such as a TRIAC. The FET may also be replaced with a more complex switching element, such as a solid-state relay. In some cases, this substitution may allow the design to dispense with the voltage protecting diode **403.** In addition, use of an optically triggered solid state relay may provide further isolation, especially galvanic isolation, between the control circuit and the suppression path.

Similarly, some embodiments may replace the diode **403** with other devices or methods of rectification and voltage limiting. These could be circuits that combine the diode with resistors or other components or components that use simple switching circuits. However, these alternatives may interfere with the suppression path that is shunting arc-creating voltages from the protected component.

Other alternative embodiments vary the manner in which the circuit is connected to the protected component as shown in **FIG 4****.** These variations cover inclusion of the inventive concept in switch casings or cable assemblies, as discussed in the preceding section. Some embodiments may be embodied as an independent component with leads for attachment to the input and output terminals **103** and **107,** or it may involve other attachment methods/devices. For example, an insulation piercing contact (IPC) would allow the creation of a solid electrical connection to an insulated wire.

The invention can be particularly suited for vehicle wire harness applications connected to a vehicle battery. The wiring harness can be used in various types of vehicles, including vehicles that use an internal combustion engine (ICE) as a power source, vehicles that use an electrical battery as a power source, and hybrid vehicles that use a combination of an ICE and an electrical battery to supply power. Of course other known vehicles can be used, such as hydrogen vehicles, etc. A charging plug or switch for any of the above vehicles (but particularly the electric motor vehicles) can be adapted to include the disclosed apparatus for detecting and suppressing DC electric arcs. Of course, any switch or device that may arc in a vehicle can utilize the disclosed subject matter.

## Claims

1. An apparatus (110) for detecting and suppressing DC electric arcs at a component (104) that connects an electric power source (101) to a load (105) and that is configured to be actuable between an open position that impedes flow of electricity and a closed position that enables flow of electricity, the apparatus (110) comprising:
an input terminal (401) electrically connected to a power source side of the component (104);
an output terminal (402) electrically connected to a load side of the component (104);
a detector circuit (405) electrically connected to the input (401) and output (402) terminals so as to be electrically connected in parallel to the component (104), wherein the detector circuit (405) includes a capacitor (406) that is directly electrically connected to the input terminal (401) and a diode (407) that is directly electrically connected to the capacitor (406) at the side opposite from the input terminal (401), and
a switching circuit (404) that conducts electricity from the power source side of the component to the load side of the component (104); wherein
the detector circuit being configured to detect a significant voltage spike across the component (104) upon the component (104) actuating between open and closed positions, the detector circuit (405) also being configured to transmit a control signal upon detecting the significant voltage spike, the detector circuit (405) including multiple circuit elements, enabling both the detection of the significant voltage spike and the transmission of the control signal, that are directly electrically connected to each other; and
the switching circuit (404) conducts electricity from the power source side of the component to the load side of the component (104) upon receipt of the control signal;
**characterized in that**
the detector circuit (405) includes a resistor (408) one side of which is directly electrically connected between the capacitor (406) at a side opposite from the input terminal (401) and the diode (407) and the other side of which is directly electrically connected to the output terminal (402); and
the detector circuit (405) includes a Zener diode (410) and another resistor (409), the Zener diode (410) being directly electrically connected on one side between the diode (407) and the switching circuit (404) and on the other side through the other resistor (409) to the output terminal (402).

2. The apparatus (110) of claim 1, wherein the significant voltage spike constitutes a voltage sufficient to cause electric arcing within the component (104).

3. The apparatus (110) of claim 1, wherein the resistor (408) provides at least 10 KΩ impedance.

4. The apparatus (110) of claim 1, wherein the other resistor (409) provides an impedance that is substantially less than an impedance provided by the resistor (408).

5. The apparatus (110) of claim 1 or 4, wherein the switching circuit includes a solid state triggerable switch (404) that is configured to receive the control signal from the detector circuit (405), and upon receipt of the control signal, to conduct electricity from the input terminal (401) to the output terminal (402).

6. The apparatus (110) of claim 5, wherein the solid state triggerable switch (404) is a Field Effect Transistor (FET).

7. The apparatus (110) of claim 5, wherein the switching circuit includes a diode (403) electrically connecting the solid state triggerable switch (404) to the input terminal (401), the diode (403) being configured to limit current between the input terminal (401) and the solid state triggerable switch (404).

8. The apparatus (110) of claim 5, wherein the solid state triggerable switch (404) is a Silicon Controlled Rectifier.

9. The apparatus (110) of claim 5, wherein the solid state triggerable switch (404) is an Opto-Electronic Switch.

10. A method for detecting and suppressing DC electric arcs at a component (104) that connects an electric power source (101) to a load (105) and that is configured to be actuable between an open position that impedes flow of electricity and a closed position that enables flow of electricity, the method comprising:
electrically connecting an input terminal (401) to a power source side of the component (104);
electrically connecting an output terminal (402) to a load side of the component (104);
electrically connecting a detector circuit (405) to the input (401) and output (402) terminals so as to be electrically connected in parallel to the component (104), wherein the detector circuit (405) includes a capacitor (406) that is directly electrically connected to the input terminal (401) and a diode (407) that is directly electrically connected to the capacitor (406) at the side opposite from the input terminal (401), and
conducting electricity from the power source side of the component (104) to the load side of the component (104); wherein
the detector circuit (405) being configured to detect a significant voltage spike across the component (104) upon the component (104) actuating between open and closed positions, the detector circuit (405) also being configured to transmit a control signal upon detecting the significant voltage spike, the detector circuit (405) including multiple circuit elements, enabling both the detection of the significant voltage spike and the transmission of the control signal, that are directly electrically connected to each other; and
the step of conducting electricity from the power source side of the component (104) to the load side of the component (104) is performed upon a switching circuit (404) receiving the control signal;
**characterized in that**
the detector circuit (405) includes a resistor (408) one side of which is directly electrically connected between the capacitor (406) at a side opposite from the input terminal (401) and the diode (407) and the other side of which is directly electrically connected to the output terminal (402); and
the detector circuit further including a Zener diode (410) and another resistor (409), the Zener diode (410) being directly electrically connected on one side between the diode (407) and the switching circuit (404) and on the other side through the other resistor (409) to the output terminal (402).

## Patentansprüche

1. Vorrichtung (110) zum Erfassen und Unterdrücken von Gleichstromlichtbögen an einer Komponente (104), die eine elektrische Stromquelle (101) mit einer Last (105) verbindet und die ausgebildet ist, in eine offene Stellung, die einen Stromfluss verhindert, und eine geschlossene Stellung, die den Stromfluss ermöglicht, betätigbar zu sein, wobei die Vorrichtung (110) aufweist:
einen Eingangsanschluss (401), der elektrisch mit einer Stromquellenseite der Komponente (104) verbunden ist;
einen Ausgangsanschluss (402), der elektrisch mit einer Lastseite der Komponente (104) verbunden ist;
eine Detektorschaltung (405), die elektrisch mit dem Eingangsanschluss (401) und dem Ausgangsanschluss (402) derart verbunden ist, dass sie elektrisch parallel zu der Komponente (104) geschaltet ist, wobei die Detektorschaltung (405) einen Kondensator (406), der direkt elektrisch mit dem Eingangsanschluss (401) verbunden ist, und eine Diode (407) aufweist, die direkt elektrisch mit dem Kondensator (406) an der dem Eingangsanschluss (401) gegenüberliegenden Seite verbunden ist, und
eine Schalterschaltung (404), die Strom von der Stromquellenseite der Komponente zur Lastseite der Komponente (104) leitet; wobei
die Detektorschaltung ausgebildet ist, eine signifikante Spannungsspitze an der Komponente (104) zu erfassen, wenn die Komponente (104) zwischen offener und geschlossener Stellung umschaltet, wobei die Detektorschaltung (405) ferner ausgebildet ist, bei Erfassung der signifikanten Spannungsspitze ein Steuersignal zu senden, wobei die Detektorschaltung (405) mehrere Schaltungselemente enthält, die sowohl die Erfassung der signifikanten Spannungsspitze als auch das Senden des Steuersignals ermöglichen und die direkt elektrisch miteinander verbunden sind; und
die Schalterschaltung (404) bei Empfang des Steuersignals Strom von der Stromquellenseite der Komponente zur Lastseite der Komponente (104) leitet;
**dadurch gekennzeichnet, dass**
die Detektorschaltung (405) einen Widerstand (408) enthält, dessen eine Seite direkt elektrisch zwischen dem Kondensator (406) an einer dem Eingangsanschluss (401) gegenüberliegenden Seite und der Diode (407) angeschlossen ist und dessen andere Seite direkt elektrisch mit dem Ausgangsanschluss (402) verbunden ist; und
die Detektorschaltung (405) eine Zener-Diode (410) und einen weiteren Widerstand (409) enthält, wobei die Zener-Diode (410) auf einer Seite direkt elektrisch zwischen der Diode (407) und der Schalterschaltung (404) und auf der anderen Seite über den anderen Widerstand (409) mit dem Ausgangsanschluss (402) verbunden ist.

2. Vorrichtung (110) nach Anspruch 1, wobei die signifikante Spannungsspitze eine Spannung darstellt, die ausreicht, um einen elektrischen Lichtbogen innerhalb der Komponente (104) zu verursachen.

3. Vorrichtung (110) nach Anspruch 1, wobei der Widerstand (408) eine Impedanz von mindestens 10 KΩ aufweist.

4. Vorrichtung (110) nach Anspruch 1, wobei der andere Widerstand (409) eine Impedanz bereitstellt, die wesentlich geringer ist als die von dem Widerstand (408) bereitgestellte Impedanz.

5. Vorrichtung (110) nach Anspruch 1 oder 4, wobei die Schalterschaltung einen auslösbaren Halbleiterschalter (404) enthält, der ausgebildet ist, das Steuersignal aus der Detektorschaltung (405) zu empfangen und bei Empfang des Steuersignals Strom von dem Eingangsanschluss (401) zu dem Ausgangsanschluss (402) zu leiten.

6. Vorrichtung (110) nach Anspruch 5, wobei der auslösbare Halbleiterschalter (404) ein Feldeffekttransistor (FET) ist.

7. Vorrichtung (110) nach Anspruch 5, wobei die Schalterschaltung eine Diode (403) enthält, die den auslösbaren Halbleiterschalter (404) mit dem Eingangsanschluss (401) elektrisch verbindet, wobei die Diode (403) ausgebildet ist, den Strom zwischen dem Eingangsanschluss (401) und dem auslösbaren Halbleiterschalter (404) zu begrenzen.

8. Vorrichtung (110) nach Anspruch 5, wobei der auslösbare Halbleiterschalter (404) ein gesteuerter Siliziumgleichrichter ist.

9. Vorrichtung (110) nach Anspruch 5, wobei der auslösbare Halbleiterschalter (404) ein optoelektronischer Schalter ist.

10. Verfahren zum Erfassen und Unterdrücken von Gleichstromlichtbögen an einer Komponente (104), die eine elektrische Energiequelle (101) mit einer Last (105) verbindet und ausgebildet ist, in eine offene Stellung, die einen Stromfluss verhindert, und eine geschlossene Stellung, die den Stromfluss ermöglicht, betätigbar zu seint, wobei das Verfahren umfasst:
elektrisches Verbinden eines Eingangsanschlusses (401) mit einer Stromquellenseite der Komponente (104);
elektrisches Verbinden eines Ausgangsanschlusses (402) mit einer Lastseite des Bauteils (104);
elektrisches Verbinden einer Detektorschaltung (405) mit dem Eingangsanschluss (401) und dem Ausgangsanschluss (402) derart, dass sie elektrisch parallel zu der Komponente (104) geschaltet ist, wobei die Detektorschaltung (405) einen Kondensator (406), der direkt elektrisch mit dem Eingangsanschluss (401) verbunden ist, und eine Diode (407) enthält, die direkt elektrisch mit dem Kondensator (406) an der dem Eingangsanschluss (401) gegenüberliegenden Seite verbunden ist, und
Leiten von Strom von der Stromquellenseite der Komponente (104) zu der Lastseite der Komponente (104); wobei
die Detektorschaltung (405) ausgebildet ist, eine signifikante Spannungsspitze an der Komponente (104) zu erfassen, wenn die Komponente (104) zwischen einer offenen und einer geschlossenen Stellung umschaltet, wobei die Detektorschaltung (405) ferner ausgebildet ist, beim Erfassen der signifikanten Spannungsspitze ein Steuersignal zu senden, wobei die Detektorschaltung (405) mehrere Schaltungselemente enthält, die sowohl die Erfassung der signifikanten Spannungsspitze als auch das Senden des Steuersignals ermöglichen, die direkt elektrisch miteinander verbunden sind; und
der Schritt des Leitens von Strom von der Energiequellenseite der Komponente (104) zur Lastseite der Komponente (104) daraufhin durchgeführt wird, dass eine Schalterschaltung (404) das Steuersignal empfängt;
**dadurch gekennzeichnet, dass**
die Detektorschaltung (405) einen Widerstand (408) enthält, dessen eine Seite direkt elektrisch zwischen dem Kondensator (406) an einer dem Eingangsanschluss (401) gegenüberliegenden Seite und der Diode (407) angeschlossen ist und dessen andere Seite direkt elektrisch mit dem Ausgangsanschluss (402) verbunden ist; und
die Detektorschaltung ferner eine Zenerdiode (410) und einen weiteren Widerstand (409) enthält, wobei die Zenerdiode (410) auf einer Seite direkt elektrisch zwischen der Diode (407) und der Schalterschaltung (404) und auf der anderen Seite über den anderen Widerstand (409) mit dem Ausgangsanschluss (402) verbunden ist.

## Revendications

1. Appareil (110) de détection et de suppression d'arcs électriques DC au niveau d'un composant (104) qui connecte une source d'énergie électrique (101) à une charge (105) et qui est conçu pour pouvoir être actionné entre une position ouverte qui bloque le flux d'électricité et une position fermée qui active le flux d'électricité, l'appareil (110) comprenant :
une borne d'entrée (401) électriquement connectée à un côté source d'alimentation du composant (104) ;
une borne de sortie (402) électriquement connectée à un côté de charge du composant (104) ;
un circuit détecteur (405) électriquement connecté aux bornes d'entrée (401) et de sortie (402) afin d'être électriquement connecté en parallèle au composant (104),
le circuit détecteur (405) comprenant un condensateur (406) qui est directement électriquement connecté à la borne d'entrée (401) et une diode (407) qui est directement électriquement connectée au condensateur (406) au niveau du côté opposé depuis la borne d'entrée (401), et
un circuit de commutation (404) qui conduit l'électricité depuis le côté source d'alimentation du composant vers le côté de charge du composant (104) ;
le circuit détecteur étant conçu pour détecter une pointe de tension significative à travers le composant (104) lorsque le composant (104) actionne entre les positions ouverte et fermée, le circuit détecteur (405) étant également conçu pour transmettre un signal de commande lors de la détection de la pointe de tension significative, le circuit détecteur (405) comprenant de multiples éléments de circuit, permettant à la fois la détection de la pointe de tension significative et la transmission du signal de commande, qui sont directement électriquement connectés les uns aux autres ; et
le circuit de commutation (404) conduisant de l'électricité depuis le côté source d'alimentation du composant vers le côté de charge du composant (104) lors de la réception du signal de commande ;
**caractérisé en ce que**
le circuit détecteur (405) comprend une résistance (408) dont un côté est directement électriquement connecté entre le condensateur (406) au niveau d'un côté opposé depuis la borne d'entrée (401) et la diode (407) et dont l'autre côté est directement électriquement connecté à la borne de sortie (402) ; et
le circuit détecteur (405) comprend une diode Zener (410) et une autre résistance (409), la diode Zener (410) étant directement électriquement connectée sur un côté entre la diode (407) et le circuit de commutation (404) et sur l'autre côté à travers l'autre résistance (409) à la borne de sortie (402).

2. Appareil (110) selon la revendication 1, la pointe de tension significative constituant une tension suffisante pour entraîner un arc électrique à l'intérieur du composant (104).

3. Appareil (110) selon la revendication 1, la résistance (408) fournissant une impédance d'au moins 10 KΩ.

4. Appareil (110) selon la revendication 1, l'autre résistance (409) fournissant une impédance qui est sensiblement inférieure à une impédance fournie par la résistance (408).

5. Appareil (110) selon la revendication 1 ou 4, le circuit de commutation comprenant un commutateur pouvant être déclenché à l'état solide (404) qui est conçu pour recevoir le signal de commande depuis le circuit détecteur (405), et à l'issue de la réception du signal de commande, pour conduire de l'électricité depuis la borne d'entrée (401) vers la borne de sortie (402).

6. Appareil (110) selon la revendication 5, le commutateur pouvant être enclenché à l'état solide (404) étant un transistor à effet de champ (TES).

7. Appareil (110) selon la revendication 5, le circuit de commutation comprenant une diode (403) connectant électriquement le commutateur pouvant être enclenché à l'état solide (404) à la borne d'entrée (401), la diode (403) étant conçue pour limiter le courant entre la borne d'entrée (401) et le commutateur pouvant être enclenché à l'état solide (404).

8. Appareil (110) selon la revendication 5, le commutateur pouvant être enclenché à l'état solide (404) étant un redresseur commandé au silicium.

9. Appareil (110) selon la revendication 5, le commutateur pouvant être enclenché à l'état solide (404) étant un commutateur optoélectronique.

10. Procédé de détection et de suppression d'arcs électriques DC au niveau d'un composant (104) qui connecte une source d'énergie électrique (101) à une charge (105) et qui est conçu pour pouvoir être actionné entre une position ouverte qui bloque le flux d'électricité et une position fermée qui active un flux d'électricité, le procédé comprenant :
la connexion électriquement d'une borne d'entrée (401) à un côté source d'alimentation du composant (104) ;
la connexion électriquement d'une borne de sortie (402) à un côté de charge du composant (104) ;
la connexion électriquement d'un circuit détecteur (405) aux bornes d'entrée (401) et de sortie (402) afin d'être électriquement connecté en parallèle au composant (104), le circuit détecteur (405) comprenant un condensateur (406) qui est directement électriquement connecté à la borne d'entrée (401) et une diode (407) qui est directement électriquement connectée au condensateur (406) au niveau du côté opposé depuis la borne d'entrée (401), et
la conduction d'électricité depuis le côté source d'alimentation du composant (104) vers le côté de charge du composant (104) ;
le circuit détecteur (405) étant conçu pour détecter une pointe de tension significative à travers le composant (104) lorsque le composant (104) actionne entre les positions ouverte et fermée, le circuit détecteur (405) étant également conçu pour transmettre un signal de commande lors de la détection de la pointe de tension significative, le circuit détecteur (405) comprenant de multiples éléments de circuit, permettant à la fois la détection de la pointe de tension significative et la transmission du signal de commande, qui sont directement électriquement connectés les uns aux autres ; et
l'étape de conduite d'électricité depuis le côté source d'alimentation du composant (104) vers le côté de charge du composant (104) étant effectuée lorsqu'un circuit de commutation (404) reçoit le signal de commande ;
**caractérisé en ce que**
le circuit détecteur (405) comprend une résistance (408) dont un côté est directement électriquement connecté entre le condensateur (406) au niveau d'un côté opposé depuis la borne d'entrée (401) et la diode (407) et dont l'autre côté est directement électriquement connecté à la borne de sortie (402) ; et
le circuit détecteur comprenant en outre une diode Zener (410) et une autre résistance (409), la diode Zener (410) étant directement électriquement connectée sur un côté entre la diode (407) et le circuit de commutation (404) et sur l'autre côté à travers l'autre résistance (409) à la borne de sortie (402).
